# FASCICULE DE BREVET EUROPEEN

(11) **EP 3 060 931 B1**
(45) Date de publication et mention de la délivrance du brevet: **13.09.2017**
(21) Numéro de dépôt: 14824877.6
(22) Date de dépôt: 22.10.2014
(51) Int. Cl.: G01R 31/327, H01H 9/16, H01H 47/00

(54) **DÉTECTION DE CHANGEMENT D'ÉTAT D'UN ACTIONNEUR**
ERKENNEN EINER ÄNDERUNG DES ZUSTANDS EINES AKTUATOR
DETECTING A CHANGE IN THE STATE OF AN ACTUATOR

(30) Priorité: 24.10.2013 FR 1360355
(43) Date de publication de la demande: 31.08.2016
(73) Titulaire: PSA Automobiles SA, 78300 Poissy (FR)
(72) Inventeur: BOUESSAY, Isabelle, F-94550 Chevilly Larue (FR); FERNANDES, Luis Philippe, F-94500 Champigny Sur Marne (FR)
(74) Mandataire: Jeannin, Laurent Jean-Pierre
(86) Numéro de dépôt international: PCT/FR2014/052690
(87) Numéro de publication internationale: WO 2015/059410

(56) Documents cités:
- WO-A1-97/34161
- WO-A1-2012/116824
- DE-A1- 10 315 204

## Description

La présente invention concerne de manière générale la détection de changement d'état d'un actionneur électrique, autrement appelé interrupteur. Dans le cadre de l'utilisation croissante de dispositifs de stockage d'énergie électrique (batterie, condensateurs...) notamment dans les véhicules, il faut prévoir de nombreux actionneurs pour connecter et déconnecter ces dispositifs de stockage avec leur réseau électrique qui peut être par exemple celui d'un système automobile, aéronautique ou stationnaire.

Pour des raisons de sécurité, il est important de garantir que l'actionneur a bien changé d'état et plusieurs solutions existent à ce jour.

Une première technique connue peut consister à utiliser un type d'actionneur dit "à retour d'état", c'est-à-dire que l'actionneur en question comprend un circuit supplémentaire qui envoi à un organe de surveillance l'information sur l'état ouvert ou fermé de l'actionneur. Cette solution est onéreuse et sa complexité augmente rapidement avec l'accroissement de la puissance électrique qui passe par l'actionneur.

Une autre technique consiste à mesurer les tensions en amont et aval des bornes de l'actionneur pour vérifier s'il est ouvert ou fermé. Cependant, en raison des puissances considérées, il faut prévoir des installations électroniques compatibles avec ces puissances, ce qui augmente le coût et la complexité.

On connaît par le document WO97/34161 un procédé de gestion d'un commutateur à prises de réglage dans lequel l'enregistrement des sons et leur conversion en un signal sonore démarre au début de l'opération de connexion du commutateur à prises de réglage et dans lequel le signal sonore est rectifié, converti en enveloppe de signal échantillonné numériquement et constamment mesuré par rapport à l'état du commutateur par comparaison de l'enveloppe avec une enveloppe de référence et/ou une enveloppe constamment actualisée par rapport à ladite enveloppe de référence.

Un but de la présente invention est de répondre aux inconvénients de l'art antérieur mentionnés ci-dessus et en particulier, tout d'abord, de proposer une solution simple et économique de détection du changement d'état d'un actionneur électrique.

Pour cela un premier aspect de l'invention concerne un procédé de détection de changement d'état d'un actionneur électrique, comprenant les étapes consistant à :
- enregistrer une vibration mécanique lors d'une commande de changement d'état de l'actionneur;
- comparer la vibration mécanique enregistrée avec au moins une vibration étalon de changement d'état ;
- déterminer si la vibration mécanique enregistrée correspond à ladite au moins une vibration étalon ;
- envoyer un signal d'alerte si la vibration mécanique enregistrée ne correspond pas à ladite au moins une vibration étalon. Le procédé selon l'invention propose de baser la détection sur une vibration produite lors du changement d'état de l'actionneur, ce qui rend cette détection indépendante des tensions et/ou puissances des courants électriques supportés par l'actionneur. La fiabilité est améliorée, et cette mesure de vibration mécanique est peu onéreuse à mettre en oeuvre. Chaque changement d'état de l'actionneur produit une vibration spécifique. En enregistrant cette vibration et en la comparant avec une vibration étalon associée à un changement d'état donné, il est possible de déterminer si le changement d'état commandé a bien été effectué au sein de l'actionneur.

Selon un mode de réalisation, le procédé comprend une étape consistant à envoyer un signal confirmant le changement d'état si la vibration mécanique enregistrée correspond à ladite au moins une vibration étalon.

Selon un mode de réalisation, l'étape consistant à enregistrer une vibration mécanique est une étape consistant à enregistrer un son, et l'étape consistant à comparer la vibration mécanique enregistrée avec au moins une vibration étalon de changement d'état est une étape consistant à comparer le son enregistré avec au moins un son étalon de changement d'état. Un son est particulièrement aisé à enregistrer et analyser.

Selon un mode de réalisation, le procédé comporte une étape consistant à identifier le changement d'état, en comparant la vibration mécanique enregistrée avec une vibration mécanique étalon d'un premier changement d'état, et avec une vibration mécanique étalon d'un deuxième changement d'état. Selon cette mise en oeuvre, il est possible de distinguer un premier changement d'état d'un autre. Par exemple, il est possible de distinguer une fermeture d'une ouverture d'un relais.

Selon un mode de réalisation, l'étape de comparaison comprend :
- une étape consistant à décomposer à l'aide d'une transformation de Fourier la vibration mécanique enregistrée en spectre vibratoire, et
- une étape consistant à comparer au moins une fréquence fondamentale du spectre vibratoire de la vibration mécanique enregistrée avec au moins une fréquence fondamentale de ladite au moins une vibration étalon.

Selon un mode de réalisation, l'étape de détermination de correspondance consiste à vérifier si ladite au moins une fréquence du spectre vibratoire de la vibration mécanique enregistrée est comprise dans une gamme de ±30%, et plus avantageusement ±25%, de ladite au moins une fréquence fondamentale de ladite au moins une vibration étalon.

Un deuxième aspect de l'invention concerne un dispositif de détection de changement d'état d'un actionneur électrique, comprenant :
- des moyens d'enregistrement d'une vibration mécanique agencés pour enregistrer une vibration mécanique lors d'une commande de changement d'état de l'actionneur,
- des moyens de calcul agencés pour comparer la vibration mécanique enregistrée avec au moins une vibration mécanique étalon de changement d'état, et agencés pour déterminer si la vibration mécanique enregistrée correspond à ladite au moins une vibration mécanique étalon,
- des moyens de communication agencés pour envoyer un signal d'alerte si la vibration mécanique enregistrée ne correspond pas à ladite au moins une vibration étalon.

Selon un mode de réalisation :
- les moyens d'enregistrement d'une vibration mécanique sont des moyens d'enregistrement d'un son,
- les moyens de calcul sont agencés pour comparer le son enregistré avec au moins un son étalon de changement d'état, et agencés pour déterminer si le son enregistré correspond au dit au moins un son étalon,
- les moyens de communication sont agencés pour envoyer un signal d'alerte si le son enregistré ne correspond pas au dit au moins un son étalon.

Selon un mode de réalisation, les moyens d'enregistrement du son comprennent un microphone.

Un troisième aspect de l'invention concerne un système comprenant :
- un dispositif selon le deuxième aspect,
- un actionneur électrique.

Selon un mode de réalisation, l'actionneur électrique est un actionneur électromécanique

Selon un mode de réalisation préférentiel, l'actionneur électrique est un contacteur électromécanique.

Selon un mode de réalisation, l'actionneur électrique est une électrovanne. Une électrovanne présente avantageusement une partie mobile qui émet un son lors de l'ouverture et/ou la fermeture, ce qui rend le procédé et le dispositif selon la présente invention adaptés à la détection lors du changement d'état. On peut également envisager d'enregistrer un son qui correspond à un écoulement pour déterminer si la vanne est fermée ou ouverte.

Selon un mode de réalisation, l'actionneur électrique est agencé pour présenter un son étalon de fermeture créé par un choc de deux pièces métalliques, différent d'un son étalon d'ouverture créé par un choc d'une pièce métallique et d'une pièce d'un autre matériau.

Selon un mode de réalisation, le son étalon de fermeture présente une fréquence fondamentale de fermeture supérieure ou égale au double d'une fréquence fondamentale du son étalon d'ouverture.

Un quatrième aspect de l'invention concerne un dispositif de fourniture d'énergie comprenant un système selon le troisième aspect et des moyens de stockage d'énergie électrique, dans lequel l'actionneur électrique est agencé pour connecter et/ou déconnecter les moyens de stockage d'énergie électrique à un réseau électrique. L'invention est avantageusement utilisée lorsque l'actionneur est accouplé à un dispositif de stockage d'électricité comme une batterie par exemple, car elle permet de simplifier la conception de l'actionneur. Les puissances engagées sont importantes mais l'enregistrement du son de changement d'état n'est pas influencé par le niveau de puissance engagée. De plus, comme la fiabilité est améliorée, il est possible d'utiliser un tel dispositif de fourniture d'énergie dans un véhicule par exemple. Cela permet de sécuriser l'utilisation croissante de batteries ou condensateurs de puissance qui sont connectés ou déconnectés de nombreuses fois lors du roulage d'un véhicule hybride ou électrique.

Un dernier aspect de l'invention concerne un véhicule automobile, comprenant au moins un actionneur électrique dont le changement d'état est détecté par le procédé selon le premier aspect, ou comprenant un système selon le troisième aspect de l'invention.

D'autres caractéristiques et avantages de la présente invention apparaîtront plus clairement à la lecture de la description détaillée qui suit d'un mode de réalisation de l'invention donné à titre d'exemple nullement limitatif et illustré par les dessins annexés, dans lesquels :
- les figure 1 a et 1b représentent une vue en coupe d'un actionneur électrique à l'état ouvert et fermé, respectivement ;
- la figure 2 représente un schéma du dispositif de détection de changement d'état de l'actionneur des figures 1 a et 1b ;
- les figures 3a et 3b représentent chacune un spectre sonore de l'actionneur de la figure 1, respectivement lors de l'ouverture et lors de la fermeture de l'actionneur.

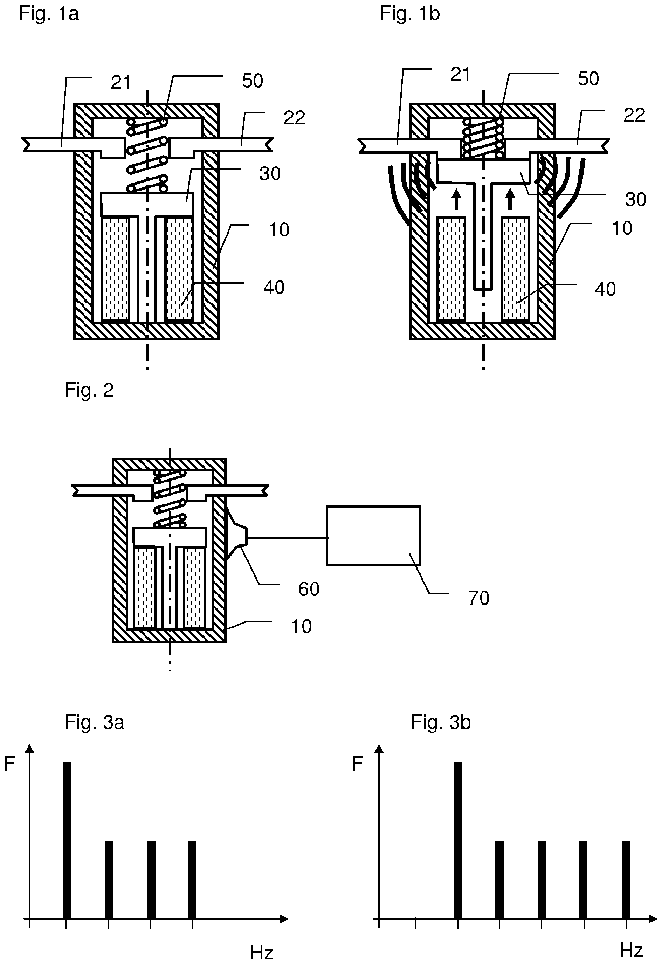

La figure 1 a représente un schéma d'un actionneur électrique qui est un contacteur électromécanique comprenant un boîtier 10, traversé par deux conducteurs métalliques formant des bornes de connexion 21 et 22, contenant à l'intérieur un pont mobile 30 en matériau conducteur de l'électricité, et une bobine 40. L'actionneur comprend également un ressort de rappel 50 qui a pour effet de repousser continuellement le pont mobile 30 des bornes de connexion 21 et 22, pour former un actionneur normalement ouvert.

Lors d'une commande de changement d'état, un courant est imposé à la bobine, ce qui a pour effet de provoquer un champ magnétique qui va forcer un déplacement du pont mobile 30 qui va entrer en contact avec les bornes de connexion 21 et 22. Le circuit électrique est alors fermé, comme représenté à la figure 1b.

Le pont mobile 30 qui entre en contact avec les bornes 21 et 22 métallique émettra alors un son qui est enregistré et analysé par le procédé selon l'invention. Un signal d'alerte est émis si le son ne correspond pas à un son étalon de fermeture de l'actionneur.

Lorsque le courant qui parcourt la bobine 40 est coupé, l'actionneur repasse alors en état ouvert, par l'action du ressort 50. Le pont mobile 30 retourne en appui sur le boîtier 10 qui est en matière isolante. A cette occasion, le pont mobile va émettre un son qui est également enregistré et analysé par le procédé selon l'invention. Un signal d'alerte est émis si le son ne correspond pas à un son étalon d'ouverture de l'actionneur.

L'actionneur lors de sa fermeture, émet un son différent du son émis lors de l'ouverture. En effet, lors de la fermeture, ce sont des pièces métalliques (le pont mobile 30 avec les bornes de connexion 21 et 22) qui entrent en contact l'une avec l'autre, alors que lors de l'ouverture, c'est une pièce métallique qui entre en contact avec une pièce en matière isolante en plastique par exemple (le pont mobile 30 avec une butée mécanique non représentée ou un revêtement isolant de la bobine 40 par exemple). Le spectre sonore est différent.

La figure 2 représente un système comprenant l'actionneur de la figure 1 a ou 1b, et un dispositif de détection de changement d'état, constitué par un microphone 60 collé sur le boîtier 10 de l'actionneur et relié à une unité de traitement du signal 70.

Lors d'une commande de changement d'état envoyée à l'actionneur, le microphone 60 transforme les vibrations mécaniques (le son émis par le pont mobile 30) sous forme d'un signal électrique envoyé à l'unité de traitement du signal 70 qui enregistre donc le son émis.

L'unité de traitement du signal 70 comprend des moyens de calcul pour comparer le signal reçu avec un son étalon gardé en mémoire, de sorte à pouvoir émettre un signal d'alerte si le son enregistré ne correspond pas au son étalon, ou un signal de confirmation que le changement d'état a bien eu lieu si le son enregistré correspond au son étalon.

Les figures 3a et 3b représentent une décomposition de spectres sonores avec une transformée de Fourier. La figure 3a représente le spectre sonore de l'actionneur lors de son ouverture, avec une fréquence fondamentale de 2000 Hz environ, qui correspond à un contact métal-plastique. On observe également quelques fréquences harmoniques.

La figure 3b représente le spectre sonore de l'actionneur lors de sa fermeture, avec une fréquence fondamentale de 4000 Hz environ, qui correspond à un contact métal-métal. On observe également quelques fréquences harmoniques.

Avec ces caractéristiques, il devient aisé de distinguer une ouverture ou une fermeture de l'actionneur, en comparant la fréquence fondamentale du spectre sonore enregistré avec des gammes de valeurs correspondant à ±25% des fréquences fondamentales des spectres sonores étalons.

Si aucun son n'est enregistré, on peut aisément déduire que l'actionneur n'a pas changé d'état et on peut également envoyer au système un signal d'alerte indiquant que le contacteur reste collé, ou est hors service.

Dans tous les cas où le spectre sonore enregistré ne correspond pas au spectre sonore étalon attendu, un signal d'alerte peut être envoyé, et un plan de levée de risque peut être lancé (réitération de la commande pour confirmation, activation d'un coupe circuit général, mise en sécurité de certains organes électriques...).

L'invention nécessite des moyens de mesure et d'enregistrement de vibrations mécaniques, et dans le cas où un son est enregistré, il faut équiper l'actionneur électrique avec un microphone qui transforme directement une vibration mécanique en signal électrique. On peut également utiliser un dispositif avec un capteur à piézoélectrique qui transforme également une vibration mécanique en signal électrique.

Dans le cas de l'utilisation d'un capteur à piézoélectrique, on peut envisager de le coller sur le boîtier 10 du contacteur électrique pour que ce dernier transmette correctement les vibrations mécaniques au capteur.

On comprendra que diverses modifications et/ou améliorations évidentes pour l'homme du métier peuvent être apportées aux différents modes de réalisation de l'invention décrits dans la présente description sans sortir du cadre de l'invention défini par les revendications annexées.

## Revendications

1. Procédé de détection de changement d'état d'un actionneur électrique (10,21,22,30,40) comprenant les étapes consistant à :
- enregistrer une vibration mécanique (60,70) lors d'une commande de changement d'état de l'actionneur commandant le passage de l'actionneur d'un premier état vers un deuxième état;
- comparer la vibration mécanique enregistrée avec au moins une vibration étalon de changement d'état associée au passage de l'actionneur depuis le premier état vers le deuxième état;
- déterminer si la vibration mécanique enregistrée correspond à ladite au moins une vibration étalon associée au passage de l'actionneur depuis le premier état vers le deuxième état, de façon à déterminer si l'actionneur est dans le deuxième état ;
- envoyer un signal d'alerte si la vibration mécanique enregistrée ne correspond pas à ladite au moins une vibration étalon, de façon à signaler que l'actionneur n'est pas dans le deuxième état.

2. Procédé selon la revendication précédente dans lequel, l'étape de comparaison comprend :
- une étape consistant à décomposer la vibration mécanique enregistrée en spectre vibratoire, et
- une étape consistant à comparer au moins une fréquence fondamentale du spectre vibratoire de la vibration mécanique enregistrée avec au moins une fréquence fondamentale de ladite au moins une vibration étalon.

3. Procédé selon la revendication précédente, dans lequel :
- l'étape consistant à enregistrer une vibration mécanique est une étape consistant à enregistrer un son, et dans lequel :
- l'étape consistant à comparer la vibration mécanique enregistrée avec au moins une vibration étalon de changement d'état est une étape consistant à comparer le son enregistré avec au moins un son étalon de changement d'état.

4. Procédé selon l'une des revendications précédentes, comportant une étape consistant à identifier le changement d'état, en comparant la vibration mécanique enregistrée avec une vibration mécanique étalon d'un premier changement d'état, et avec une vibration mécanique étalon d'un deuxième changement d'état.

5. Procédé selon l'une des revendications 2 à 4, dans lequel l'étape de décomposition de la vibration mécanique enregistrée en spectre vibratoire est réalisée à l'aide d'une transformation de Fourier.

6. Procédé selon l'une des revendications 2 à 4, dans lequel l'étape de détermination de correspondance consiste à vérifier si ladite au moins une fréquence du spectre vibratoire de la vibration mécanique enregistrée est comprise dans une gamme de ±30%, de ladite au moins une fréquence fondamentale de ladite au moins une vibration étalon.

7. Dispositif de détection de changement d'état d'un actionneur électrique (10,21,22,30,40), comprenant:
- des moyens d'enregistrement d'une vibration mécanique (60,70) agencés pour enregistrer une vibration mécanique lors d'une commande de changement d'état de l'actionneur commandant le passage de l'actionneur d'un premier état vers un deuxième état,
- des moyens de calcul agencés pour comparer la vibration mécanique enregistrée avec au moins une vibration mécanique étalon de changement d'état associée au passage de l'actionneur depuis le premier état vers le deuxième état, et agencés pour déterminer si la vibration mécanique enregistrée correspond à ladite au moins une vibration mécanique étalon,
- des moyens de communication agencés pour envoyer un signal d'alerte si la vibration mécanique enregistrée ne correspond pas à ladite au moins une vibration étalon, de façon à signaler que l'actionneur n'est pas dans le deuxième état.

8. Dispositif selon la revendication précédente dans lequel :
- les moyens d'enregistrement d'une vibration mécanique sont des moyens d'enregistrement d'un son,
- les moyens de calcul sont agencés pour comparer le son enregistré avec au moins un son étalon de changement d'état, et agencés pour déterminer si le son enregistré correspond au dit au moins un son étalon,
- les moyens de communication sont agencés pour envoyer un signal d'alerte si le son enregistré ne correspond pas au dit au moins un son étalon.

9. Système comprenant :
- un dispositif selon l'une des revendications 7 ou 8
- un actionneur électrique, préférentiellement un contacteur électromécanique.

10. Système selon la revendication précédente, dans lequel l'actionneur électrique est agencé pour présenter un son étalon de fermeture différent d'un son étalon d'ouverture.

11. Système selon la revendication précédente, dans lequel le son étalon de fermeture est créé par un choc de deux pièces métalliques, le son étalon d'ouverture étant créé par un choc d'une pièce métallique et d'une pièce d'un autre matériau.

12. Dispositif de fourniture d'énergie comprenant un système selon l'une des revendications 9 à 11, et des moyens de stockage d'énergie électrique, dans lequel l'actionneur électrique est agencé pour connecter et/ou déconnecter les moyens de stockage d'énergie électrique à un réseau électrique.

13. Véhicule automobile, comprenant au moins un actionneur électrique dont le changement d'état est détecté par le procédé selon l'une des revendications 1 à 6, ou comprenant un système selon l'une des revendications 9 à 11.

## Patentansprüche

1. Verfahren zum Erfassen einer Zustandsänderung eines elektrischen Aktuators (10, 21, 22, 30, 40), das die Schritte aufweist, die aus Folgendem bestehen:
- Aufzeichnen einer mechanischen Schwingung (60, 70) bei einer Zustandsänderungssteuerung des Aktuators, die den Übergang des Aktuators von einem ersten Zustand auf einen zweiten Zustand steuert;
- Vergleichen der aufgezeichneten mechanischen Schwingung mit mindestens einer Zustandsänderungseichschwingung, die mit dem Übergang des Aktuators von dem ersten Zustand auf den zweiten Zustand assoziiert ist;
- Bestimmen, ob die aufgezeichnete mechanische Schwingung der mindestens einen Eichschwingung, die mit dem Übergang des Aktuators von dem ersten Zustand auf den zweiten Zustand assoziiert ist, entspricht, um zu bestimmen, ob der Aktuator in dem zweiten Zustand ist;
- Senden eines Warnsignals, falls die aufgezeichnete mechanische Schwingung nicht der mindestens einen Eichschwingung entspricht, um zu melden, dass der Aktuator nicht in dem zweiten Zustand ist.

2. Verfahren nach dem vorhergehenden Anspruch, wobei der Vergleichsschritt Folgendes umfasst:
- einen Schritt, der darin besteht, die aufgezeichnete mechanische Schwingung in ein Schwingungsspektrum aufzugliedern, und
- einen Schritt, der darin besteht, mindestens eine Eigenfrequenz des Schwingungsspektrums der aufgezeichneten mechanischen Schwingung mit mindestens einer Eigenfrequenz der mindestens einen Eichschwingung zu vergleichen.

3. Verfahren nach dem vorhergehenden Anspruch, wobei:
- der Schritt, der darin besteht, eine mechanische Schwingung aufzuzeichnen, ein Schritt ist, der darin besteht, einen Schall aufzuzeichnen, und wobei:
- der Schritt, der darin besteht, die aufgezeichnete mechanische Schwingung mit mindestens einer Zustandsänderungseichschwingung zu vergleichen, ein Schritt ist, der darin besteht, den aufgezeichneten Schall mit mindestens einem Zustandsänderungseichschall zu vergleichen.

4. Verfahren nach einem der vorhergehenden Ansprüche, das einen Schritt umfasst, der darin besteht, die Zustandsänderung zu identifizieren, indem die aufgezeichnete mechanische Schwingung mit einer mechanischen Eichschwingung einer ersten Zustandsänderung und mit einer mechanischen Eichschwingung einer zweiten Zustandsänderung verglichen wird.

5. Verfahren nach einem der Ansprüche 2 bis 4, wobei der Aufgliederungsschritt der aufgezeichneten mechanischen Schwingung in ein Schwingungsspektrum mit Hilfe einer Fourier-Transformation ausgeführt wird.

6. Verfahren nach einem der Ansprüche 2 bis 4, wobei der Schritt des Bestimmens der Übereinstimmung darin besteht zu prüfen, ob die mindestens eine Frequenz des Schwingungsspektrums der aufgezeichneten mechanischen Schwingung in einem Bereich von ±30 % der mindestens einen Eigenfrequenz der mindestens einen Eichschwingung liegt.

7. Vorrichtung zum Erfassen einer Zustandsänderung eines elektrischen Aktuators (10, 21, 22, 30, 40), umfassend:
- Mittel zum Aufzeichnen einer mechanischen Schwingung (60, 70), die eingerichtet sind, um eine mechanische Schwingung bei einer Zustandsänderungssteuerung des Aktuators, die den Übergang des Aktuators von einem ersten Zustand auf einen zweiten Zustand steuert, aufzuzeichnen,
- Rechenmittel, die eingerichtet sind, um die aufgezeichnete mechanische Schwingung mit mindestens einer mechanischen Zustandsänderungseichschwingung, die mit dem Übergang des Aktuators von dem ersten Zustand auf den zweiten Zustand assoziiert ist, zu vergleichen, um zu bestimmen, ob die aufgezeichnete mechanische Schwingung der mindestens einen mechanischen Eichschwingung entspricht,
- Kommunikationsmittel, die eingerichtet sind, um ein Warnsignal zu senden, wenn die aufgezeichnete mechanische Schwingung nicht der mindestens einen Eichschwingung entspricht, so dass gemeldet wird, dass der Aktuator nicht in dem zweiten Zustand ist.

8. Vorrichtung nach dem vorhergehenden Anspruch, wobei:
- die Mittel zum Aufzeichnen einer mechanischen Schwingung Mittel zum Aufzeichnen eines Schalls sind,
- die Rechenmittel eingerichtet sind, um den aufgezeichneten Schall mit mindestens einem Zustandsänderungseichschall zu vergleichen, und eingerichtet sind, um zu bestimmen, ob der aufgezeichnete Schall dem mindestens einen Eichschall entspricht,
- die Kommunikationsmittel eingerichtet sind, um ein Warnsignal zu senden, falls der aufgezeichnete Schall nicht dem mindestens einen Eichschall entspricht.

9. System, umfassend:
- eine Vorrichtung nach einem der Ansprüche 7 oder 8,
- einen elektrischen Aktuator, bevorzugt einen elektromechanischen Aktuator.

10. System nach dem vorhergehenden Anspruch, wobei der elektrische Aktuator eingerichtet ist, um einen Schließeichschall aufzuweisen, der von einem Öffnungseichschall unterschiedlich ist.

11. System nach dem vorhergehenden Anspruch, wobei der Schließeichschall von einem Aufprall zweier metallischer Teile geschaffen wird, wobei der Öffnungseichschall von einem Aufprall eines Metallteils und eines Teils aus einem anderen Werkstoff geschaffen wird.

12. Vorrichtung zum Liefern von Energie, die ein System nach einem der Ansprüche 9 bis 11 und Stromspeichermittel umfasst, wobei der elektrische Aktuator eingerichtet ist, um die Stromspeichermittel an ein Stromnetz anzuschließen und/oder davon zu trennen.

13. Kraftfahrzeug, das mindestens einen elektrischen Aktuator umfasst, dessen Zustandsänderung durch das Verfahren nach einem der Ansprüche 1 bis 6 erfasst wird, oder das ein System nach einem der Ansprüche 9 bis 11 umfasst.

## Claims

1. A method for detecting a change in the state of an electric actuator (10, 21, 22, 30, 40), including the steps consisting of:
- recording a mechanical vibration (60, 70) during an instruction to change the state of the actuator commanding the passage of the actuator from a first state into a second state;
- comparing the recorded mechanical vibration with at least one standard change of state vibration associated with the passage of the actuator from the first state into the second state;
- determining whether the recorded mechanical vibration corresponds to said at least one standard vibration associated with the passage of the actuator from the first state into the second state, so as to determine if the actuator is in the second state;
- sending a warning signal if the recorded mechanical vibration does not correspond to said at least one standard vibration, so as to signal that the actuator is not in the second state.

2. The method according to the preceding claim, in which the comparison step includes:
- a step consisting of breaking down the recorded mechanical vibration in vibratory spectrum, and
- a step consisting of comparing at least one fundamental frequency of the vibratory spectrum of the recorded mechanical vibration with at least one fundamental frequency of said at least one standard vibration.

3. The method according to the preceding claim, in which:
- the step consisting of recording a mechanical vibration is a step consisting of recording a sound, and in which:
- the step consisting of comparing the recorded mechanical vibration with at least one standard change of state vibration is a step consisting of comparing the recorded sound with at least one standard change of state sound.

4. The method according to one of the preceding claims, comprising a step consisting of identifying the change of state, by comparing the recorded mechanical vibration with a standard mechanical vibration of a first change of state, and with a standard mechanical vibration of a second change of state.

5. The method according to one of Claims 2 to 4, in which the step of breaking down the recorded mechanical vibration in vibratory spectrum is realized by means of a Fourier transformation.

6. The method according to one of Claims 2 to 4, in which the step of determining correspondence consists in verifying whether said at least one frequency of the vibratory spectrum of the recorded mechanical vibration is comprised in a range of ±30% of said at least one fundamental frequency of said at least one standard vibration.

7. A device for detecting a change of state of an electric actuator (10, 21, 22, 30, 40), including:
- means for recording a mechanical vibration (60, 70),
arranged to record a mechanical vibration during an instruction to change the state of the actuator commanding the passage of the actuator from a first state into a second state,
- calculation means, arranged to compare the recorded mechanical vibration with at least one standard change of state mechanical vibration associated with the passage of the actuator from the first state into the second state, and arranged to determine whether the recorded mechanical vibration corresponds to said at least one standard mechanical vibration,
- communication means arranged to send a warning signal if the recorded mechanical vibration does not correspond to said at least one standard vibration, so as to signal that the actuator is not in the second state.

8. The device according to the preceding claim, in which:
- the means for recording a mechanical vibration are means for recording a sound,
- the calculation means are arranged to compare the recorded sound with at least one standard change of state sound, and arranged to determine whether the recorded sound corresponds to said at least one standard sound,
- the communication means are arranged to send a warning signal if the recorded sound does not correspond to said at least one standard sound.

9. A system including:
- a device according to one of Claims 7 or 8
- an electric actuator, preferably an electromechanical contactor.

10. The system according to the preceding claim, in which the electric actuator is arranged to present a standard closing sound different from a standard opening sound.

11. The system according to the preceding claim, in which the standard closing sound is created by an impact of two metal parts, the standard opening sound being created by an impact of one metal part and one part of another material.

12. A device for supplying energy, including a system according to one of Claims 9 to 11, and means for storing electrical energy, in which the electric actuator is arranged to connect and/or disconnect the means for storing electrical energy with respect to an electricity network.

13. A motor vehicle, including at least one electric actuator, the change of state of which is detected by the method according to one of Claims 1 to 6, or including a system according to one of Claims 9 to 11.
